# EUROPEAN PATENT APPLICATION

(11) **EP 4 383 257 A1**
(43) Date of publication of application: **12.06.2024**
(21) Application number: 23197047.6
(22) Date of filing: 13.09.2023
(51) Int. Cl.: G11C 5/02, G11C 5/04, G11C 5/06, G11C 7/10, H01L 23/48, H01L 25/065, H01L 29/78, H10B 12/00, G11C 11/4093

(54) **MEMORY DEVICE AND MEMORY SYSTEM INCLUDING THE SAME**

(30) Priority: 06.12.2022 KR 20220168846; 21.08.2023 US 202318452616
(71) Applicant: Samsung Electronics Co., Ltd., Suwon-si, Gyeonggi-do 16677 (KR)
(72) Inventor: YANG, Yunseok, 16677 Suwon-si, Gyeonggi-do (KR); JEONG, Yunkyeong, 16677 Suwon-si, Gyeonggi-do (KR); RYU, Seula, 16677 Suwon-si, Gyeonggi-do (KR); LEE, Dong Gi, 16677 Suwon-si, Gyeonggi-do (KR); AN, Minhwan, 16677 Suwon-si, Gyeonggi-do (KR); LEE, Eungchang, 16677 Suwon-si, Gyeonggi-do (KR); CHOO, Chul-Hwan, 16677 Suwon-si, Gyeonggi-do (KR)
(74) Representative: Kuhnen & Wacker Patent- und Rechtsanwaltsbüro PartG mbB

(57) **Abstract**

Disclosed is a memory device which includes a base die that includes a pair of second dies and a first die that is between the pair of second dies, and a memory stack that includes memory dies sequentially stacked on the base die in a vertical direction. The first die is electrically connected to the memory stack, and the first die includes a logic transistor including a channel of a three-dimensional structure.

## Description

### CROSS-REFERENCE TO RELATED APPLICATION(S)

This application claims priority under 35 U.S.C. § 119 to Korean Patent Application No. 10-2022-0168846 filed on December 6, 2022, in the Korean Intellectual Property Office, the disclosure of which is incorporated by reference herein in its entirety.

### BACKGROUND

Example embodiments of the present invention described herein relate to a semiconductor device, and more particularly, relate to a memory device and a memory system including the same.

A semiconductor memory is classified as a volatile memory, in which stored data disappear when a power is turned off, such as a static random access memory (SRAM) or a dynamic random access memory (DRAM) or a nonvolatile memory, in which stored data are retained even when a power is turned off, such as a flash memory device, a phase-change RAM (PRAM), a magnetic RAM (MRAM), a resistive RAM (RRAM), or a ferroelectric RAM (FRAM).

A high-bandwidth memory device may have a structure in which a plurality of memory dies and a base die (or referred to as a "buffer die") are stacked. The plurality of memory dies may be stacked on the base die, and the plurality of memory dies may receive a command and an address from the base die by using through silicon vias (TSV) penetrating the plurality of memory dies and may exchange the data with the base die therethrough.

A system device including a high-bandwidth memory device may include a high-bandwidth memory device and a control device (e.g., a graphic processing unit (GPU) die, a central processing unit (CPU) die, or a system on chip (SoC)). The base die of the high-bandwidth memory device may receive a command and an address transmitted from the control device and may exchange the data with the control device.

### SUMMARY

Example embodiments of the present invention provide a memory device capable of improving an operating speed and reducing manufacturing costs.

According to some embodiments, a memory device includes a base die structure that includes a first die and a second die that may be separated from the first die, and a memory stack that includes memory dies sequentially stacked on the base die structure in a vertical direction. The first die is electrically connected to the memory stack, and the first die includes a logic transistor (e.g., a transistor of a logic circuit) including a channel of a three-dimensional structure.

According to some embodiments, a memory system includes a host that generates a data signal and a command address signal, and a memory device that receives the data signal and the command address signal from the host. The memory device includes a base die structure that includes a first die configured to receive the data signal and a second die configured to receive the command address signal, and a memory stack that includes memory dies sequentially stacked on the base die structure in a vertical direction, and the first die includes a logic transistor (e.g., a transistor of a logic circuit) including a channel of a three-dimensional structure.

According to an embodiment, a semiconductor package includes a package substrate, an interposer substrate that is provided on the package substrate, a logic die that is provided on the interposer substrate and generates a data signal and a command address signal, and a memory device that is provided on the interposer substrate and is mounted side by side with the logic die. The memory device includes a base die structure that includes a pair of second dies and a first die disposed between the pair of second dies, and a memory stack that includes memory dies sequentially stacked on the base die structure in a vertical direction. The first die receives the data signal and the command address signal, and the first die includes a logic transistor (e.g., a transistor of a logic circuit) including a channel of a three-dimensional structure.

### BRIEF DESCRIPTION OF DRAWINGS

The above and other objects and features of the present invention will become apparent by describing in detail embodiments thereof with reference to the accompanying drawings.
FIG. 1 is a block diagram illustrating a memory system according to some embodiments of the present invention.
FIG 2 is a block diagram illustrating configurations of a base die and a first die of FIG. 1.
FIG. 3 is a plan view of a high-bandwidth memory device of FIG. 1, according to some embodiments of the present invention.
FIG. 4 is a cross-sectional view of a high-bandwidth memory device taken along line I-I' of FIG. 3 according to some embodiments of the present invention.
FIG. 5 is an enlarged view of region "M" of FIG. 4, according to some embodiments of the present invention.
FIG. 6 is an enlarged view of region "M" of FIG. 4, according to some other embodiments of the present invention.
FIG. 7 is an enlarged view of region "N" of FIG. 4, according to some embodiments of the present invention.
FIG. 8 is an enlarged view of region "O" of FIG. 4, according to some embodiments of the present invention.
FIG. 9 is an enlarged view of region "O" of FIG. 4, according to some other embodiments of the present invention.
FIG. 10 is an enlarged view of region "O" of FIG. 4, according to some other embodiments of the present invention.
FIG. 11 is a plan view of a high-bandwidth memory device of FIGS. 1 and 2, according to some embodiments of the present invention.
FIG. 12 is a cross-sectional view of a high-bandwidth memory device taken along line II-II' of FIG. 11 according to some embodiments of the present invention.
FIG. 13 is a block diagram illustrating a memory system according to some embodiments of the present invention.
FIG 14 is a block diagram illustrating a configuration of a base die of FIG. 13 according to some embodiments of the present invention.
FIG. 15 is a plan view of a high-bandwidth memory device of FIGS. 13 and 14, according to some embodiments of the present invention.
FIG. 16 is a cross-sectional view of a high-bandwidth memory device taken along line III-III' of FIG. 15 according to some embodiments of the present invention.
FIG. 17 is a plan view of a semiconductor package including a high-bandwidth memory device according to some embodiments of the present invention.
FIG. 18 is a cross-sectional view of a semiconductor package taken along line IV- IV' of FIG. 17 according to some embodiments of the present invention.
FIG. 19 is a cross-sectional view of a semiconductor package taken along line V-V' of FIG. 17 according to some embodiments of the present invention.

### DETAILED DESCRIPTION

Below, example embodiments of the present invention will be described in detail and clearly to such an extent that one skilled in the art easily carries out the present invention.

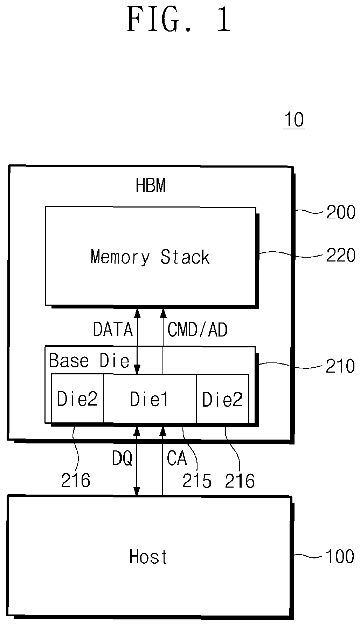

FIG. 1 is a block diagram illustrating a memory system according to some embodiments of the present invention.

Referring to FIG. 1, a memory system 10 may include a host 100 and a high-bandwidth memory device 200.

The host 100 may be configured to generate various kinds of signals for controlling a memory operation of the high-bandwidth memory device 200, such as a read operation or a write operation. For example, the host 100 may be configured to generate a command address signal CA including various kinds of command information and address information (hereinafter referred to as "command address information") for accessing the high-bandwidth memory device 200 and a data signal DQ including data information to be written in the high-bandwidth memory device 200. Also, the host 100 may be configured to receive the data signal DQ including the read data information.

The host 100 may include a graphic processing unit (GPU), a central processing unit (CPU), or a system on chip (SoC).

The high-bandwidth memory device 200 may include a base die (also referred to as "a buffer die" or "a base die structure") 210 and a memory stack 220.

The base die 210 may be configured to receive various kinds of signals from the host 100 and to perform the access to the memory stack 220.

The base die 210 may include a first die 215 and a second die 216. The first die 215 may be formed by performing a first process. For example, the first process may be a logic manufacturing process for manufacturing a logic circuit. The second die 216 may be formed by performing a second process. The second process may be a memory manufacturing process for manufacturing a memory cell array and a peripheral circuit. As used herein, the term "die" may refer a chip (e.g., an unpackaged, bare chip) that includes a portion of a substrate (e.g., a wafer) and integrated circuits fabricated on that portion of the substrate. Accordingly, two separate dies may include two separate portions of different substrates or two separate portions of a single substrate.

The first die 215 and the second die 216 may be separated from each other and disposed. For example, the first die 215 and the second die 216 may not be integrally provided and may be two separate dies. For example, the first die 215 and the second die 216 may be spaced from each other, and an adhesive layer may be provided between the first die 215 and the second dies 216.

In some embodiments, the first die 215 may be disposed between a pair of second dies 216. However, the arrangement relationship between the first die 215 and the second dies 216 is not limited thereto and may be variously changed or modified.

The first die 215 may be configured to receive the command address signal CA from the host 100. The first die 215 may be configured to provide the memory stack 220 a command/address CMD/AD including command address information based on the command address signal CA.

The first die 215 may be configured to receive the data signal DQ. The first die 215 may be configured to provide the memory stack 220 with data "DATA" including the data information to be written in the memory stack 220 based on the data signal DQ. Also, the first die 215 may be configured to generate the data signal DQ based on the data "DATA" read from the memory stack 220.

However, the present invention is not limited thereto. For example, the first die 215 may further include integrated circuits configured to control the memory operation of the high-bandwidth memory device 200.

The second die 216 may be disposed on the side surface of the first die 215. For example, the second die 216 may be provided in plurality, and first and second groups of the plurality of second dies 216 may be respectively disposed on opposite surfaces of the first die 215. As another example, the second die 216 may be disposed on one side surface of the first die 215.

The second die 216 may be provided to improve the stability and reliability of arrangement between the memory stack 220 and the base die 210 in the high-bandwidth memory device 200 and may not be concerned in the memory operation. For example, the second die 216 may not be electrically connected to the memory stack 220, but the present invention is not limited thereto.

According to some embodiments of the present invention, the first die 215 that transmits/receives various kinds of signals may be formed by performing the first process, and the second die 216 and a memory die may be formed by performing the second process. As such, according to the present invention, the degree of integration and an operating speed of an internal circuit of the base die 210 may be improved compared to the case where the entire base die 210 is formed by the second process, and manufacturing costs may be reduced compared to the case where the entire base die 210 is formed by the first process.

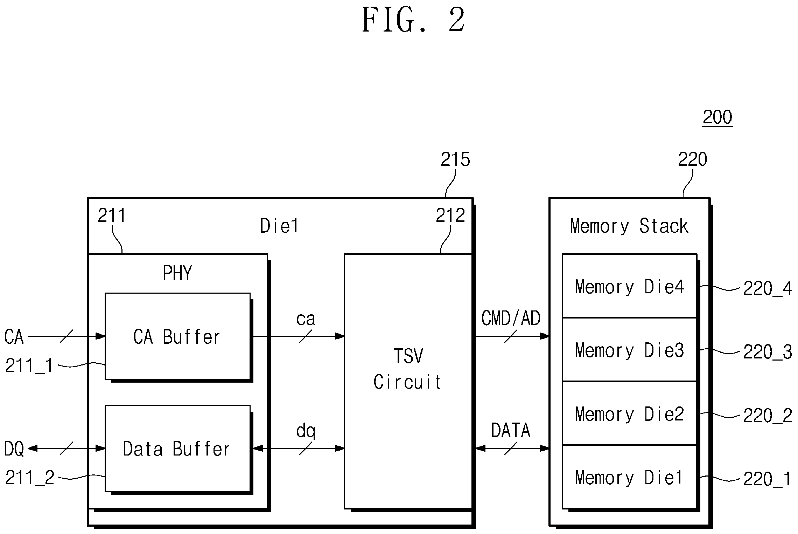

FIG. 2 is a block diagram illustrating configurations of a base die and a first die of FIG. 1.

Referring to FIG. 2, the first die 215 may include a physical layer interface 211 and a through silicon via (TSV) circuit 212.

The physical layer interface 211 may be configured to store command address information ca and data information dq based on the command address signal CA and the data signal DQ received from the host 100.

The physical layer interface 211 may include a command address buffer 211_1 and a data buffer 211_2.

The command address buffer 211_1 may be configured to store the command address information ca based on the command address signal CA received through the host 100. The command address buffer 211_1 may be configured to provide the stored command address information ca to the TSV circuit 212.

The data buffer 211_2 may be configured to store the data information dq based on the data signal DQ received through the host 100. The data buffer 211_2 may be configured to provide the stored data information dq to the TSV circuit 212.

The TSV circuit 212 may be electrically connected to the memory stack 220. The TSV circuit 212 may be configured to receive the command address information ca and the data information dq from the physical layer interface 211. The TSV circuit 212 may be configured to provide the command/address CMD/AD to the memory stack 220 based on the received command address information ca. The TSV circuit 212 may be configured to provide the data "DATA" to the memory stack 220 based on the received data information dq.

When the read operation is performed, the TSV circuit 212 may be configured to receive the data "DATA" from the memory stack 220 and to provide the data information dq to the physical layer interface 211.

The memory stack 220 may include a plurality of memory dies 220_1 to 220_4. The memory stack 220 may be configured to perform the memory operation based on the command address and the data received from the first die 215.

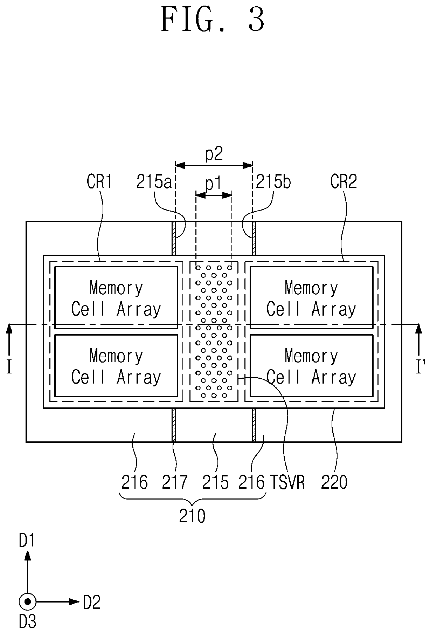

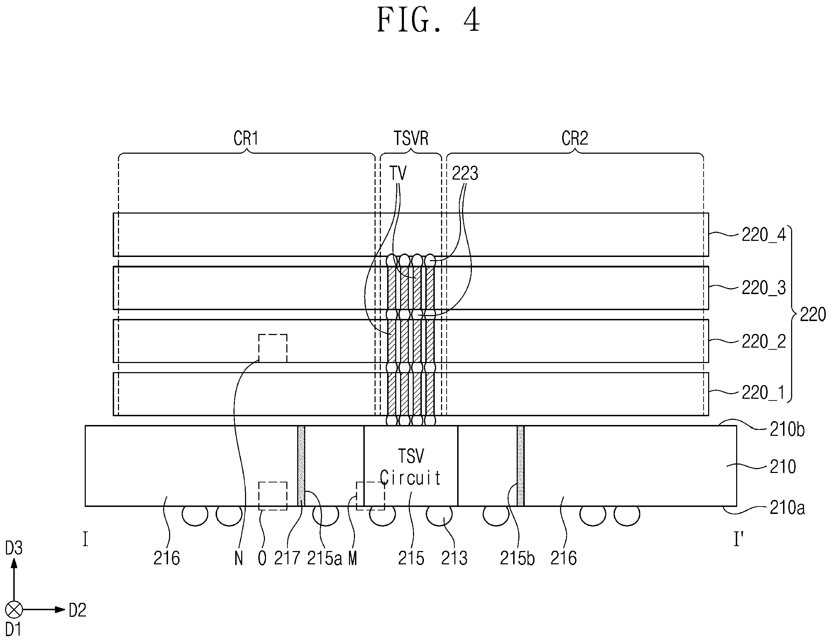

FIG. 3 is a plan view of a high-bandwidth memory device of FIG. 1, according to some embodiments. FIG. 4 is a cross-sectional view of a high-bandwidth memory device taken along line I-I' of FIG. 3.

Referring to FIGS. 3 and 4, the high-bandwidth memory device 200 may include the base die 210 and the memory stack 220 disposed on the base die 210.

The base die 210 may be provided on a plane defined by a first direction D1 (also referred to a first horizontal direction) and a second direction D2 (also referred to a second horizontal direction) perpendicular to the first direction D1. The base die 210 may have a first surface 210a on which connection terminals 213 are disposed and a second surface 210b facing away from or opposite the first surface 210a. The memory stack 220 may include the first to fourth memory dies 220_1 to 220_4 that are sequentially stacked on the second surface 210b of the base die 210 along a third direction D3 (also referred to a vertical direction) perpendicular to the first direction D1 and the second direction D2.

The first to fourth memory dies 220_1 to 220_4 may be, for example, dynamic random access memory (DRAM) chips. According to some embodiments, the first to fourth memory dies 220_1 to 220_4 may have substantially the same chip size. In some embodiments, the first to fourth memory dies 220_1 to 220_4 may have substantially the same shape and size in a plan view.

The first to fourth memory dies 220_1 to 220_4 may be formed through the second process. For example, the second process may be a process for manufacturing dynamic random access memory chips.

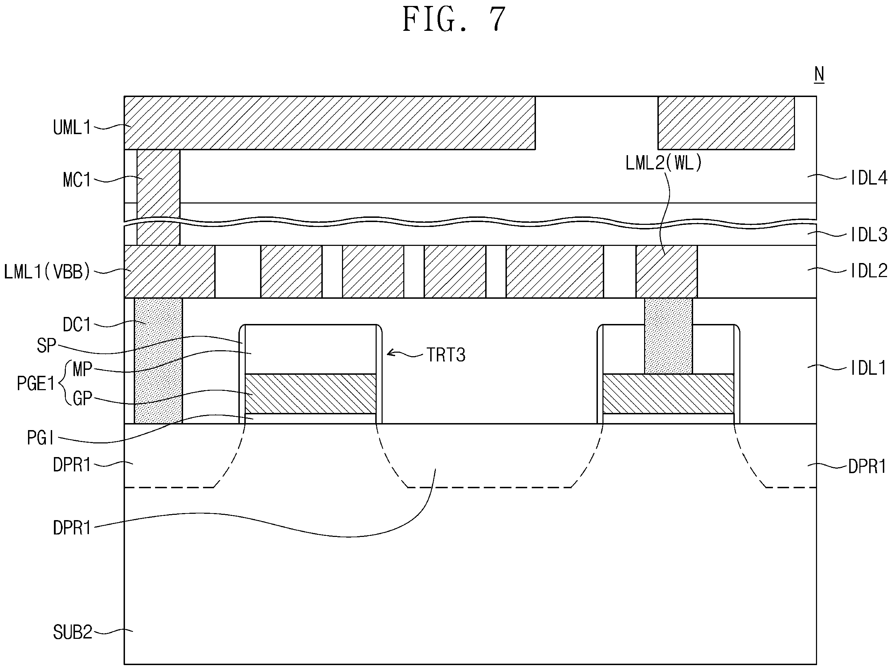

The first to fourth memory dies 220_1 to 220_4 formed through the second process may include memory transistors and wiring layers. The memory transistors and the wiring layers of the first to fourth memory dies 220_1 to 220_4 may constitute a memory circuit. The memory transistors and the wiring layers will be described in detail with reference to FIG. 7.

Each of the first to fourth memory dies 220_1 to 220_4 may include a first cell region CR1, a second cell region CR2, and a through via region TSVR.

In each of the first to fourth memory dies 220_1 to 220_4, the first cell region CR1 and the second cell region CR2 may be defined as a region where memory cell arrays are disposed. The first cell region CR1 and the second cell region CR2 may be located adjacent to opposite side surfaces of the relevant memory die.

A plurality of memory cell arrays may be provided in the first cell region CR1 and the second cell region CR2. For example, each of the memory cell arrays may include memory cells. The shape of the first cell region CR1 and the second cell region CR2 and the arrangement of the memory cell arrays may be modified unlike the example illustrated in drawing.

In each of the first to fourth memory dies 220_1 to 220_4, the through via region TSVR may be defined as a region where through vias TV of each memory die are formed. Terminals 223 may be provided on the through via region TSVR. The terminals 223 may be micro terminals. The through vias TV may be respectively connected to the terminals 223 on the through via region TSVR. The through vias TV may be in (e.g., may penetrate or extend through) memory dies. Each memory die may receive the data "DATA" and the command/address CMD/AD from the base die 210 through the terminals 223 and the through vias TV connected thereto. As used herein "an element A penetrates an element B" (or similar language) may mean that at least a portion of the element A extends into the element B such that the at least a portion of the element A is in the element B.

The through via region TSVR may be disposed between the first cell region CR1 and the second cell region CR2. In some embodiments, the through via region TSVR may be disposed on central portions of memory dies and may extend in the first direction D1. As used herein, "an element A extends in a direction X" (or similar language) may mean that the element A extends longitudinally in the direction X.

The base die 210 may include the first die 215 and the second dies 216. The first die 215 may be configured to be electrically connected to the memory stack 220. The second dies 216 may not be electrically connected to the first die 215.

The first die 215 may include terminals, wires, and integrated circuits. For example, the first die 215 may include the physical layer interface 211 and the TSV circuit 212 illustrated in FIG. 2. For example, the first die 215 may further include integrated circuits that operate at high speed.

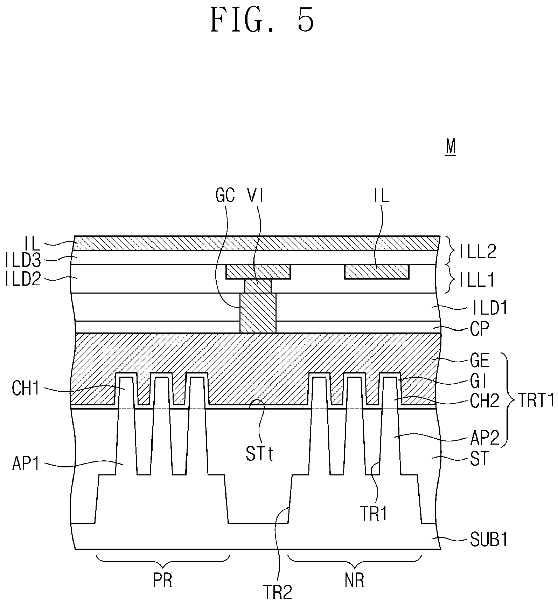

The first die 215 may include logic transistors having a channel of a three-dimensional structure, and the second dies 216 may include transistors having a planar gate electrode. This will be described with reference to FIGS. 5 to 9. As used herein, "a logic transistor" may refer to a transistor of a logic circuit.

In some embodiments, the second die 216 may be spaced from the first die 215. For example, an adhesive layer 217 may be provided between the first die 215 and the second die 216. In some other embodiments, unlike the example illustrated in drawing, the first die 215 and the second die 216 may be provided to directly contact each other; in this case, the adhesive layer 217 may not be provided.

In some embodiments, the first die 215 may be disposed between a pair of second dies 216. For example, the second die 216, the first die 215, and the second die 216 may be sequentially disposed along the second direction D2. For example, the first die 215 may be disposed on the central portion of the base die 210 and may extend in the first direction D1. For example, the pair of second dies 216 may be respectively disposed on opposite side surfaces of the base die 210 and may extend in the first direction D1. However, the arrangement/location of the first die 215 and the arrangement relationship with the second die 216 may be variously changed or modified unlike the example illustrated in drawing.

The first die 215 and the second dies 216 may have the same height (e.g., the same thickness in the third direction D3). The upper surfaces of the first die 215 and the second dies 216 may be coplanar. In other words, the upper surface of the first die 215 and the upper surfaces of the second dies 216 may be disposed on the same plane, and the lower surface of the first die 215 and the lower surfaces of the second dies 216 may be disposed on the same plane.

In the base die 210, the area occupied by the second dies 216 may be larger than the area occupied by the first die 215. For example, in a plan view, the second dies 216 may occupy 50% to 80% of the base die 210, and the first die 215 may occupy the remaining 20% to 50% of the base die 210. In some embodiments of the present invention, as the occupying area of the second dies 216 in the base die 210 increases, manufacturing costs of the base die 210 may be further reduced.

The first die 215 may be disposed to vertically overlap the through via region TSVR of memory dies. For example, at least a portion of the first die 215 may overlap the through via region TSVR in the third direction D3. As used herein, "an element A vertically overlapping an element B" (or similar language) may mean that at least one vertical line can be drawn that intersects both elements A and B.

The first die 215 may include a first side surface 215a and a second side surface 215b facing away from or opposite the first side surface 215a. The second dies 216 may extend in the first direction D1 along the first side surface 215a and the second side surface 215b of the first die 215.

In some embodiments, the first side surface 215a of the first die 215 may vertically overlap the first cell region CR1, and the second side surface 215b of the first die 215 may vertically overlap the second cell region CR2. For example, the first side surface 215a may overlap at least one of memory cell arrays on the first cell region CR1 in the third direction D3, and the second side surface 215b may overlap at least one of memory cell arrays on the second cell region CR2 in the third direction D3.

A width p2 of the first die 215 may be defined as a length extending in the second direction D2 between the first side surface 215a and the second side surface 215b. A width p1 of the through via region TSVR may be defined a maximum length extending in the second direction D2 between terminals on the through via region TSVR. In some embodiments, the width p2 of the first die 215 may be greater than the width p1 of the through via region TSVR.

The connection terminals 213 may be provided on the first surface 210a of the base die 210. For example, the connection terminals 213 provided on the lower surface of the first die 215 may be configured to receive various kinds of signals from the host 100 of FIG. 1. For example, the connection terminals 213 provided on the lower surface of the second die 216 may be configured to be electrically connected to internal wires of the second die 216. For example, the connection terminals 213 provided on the lower surface of the second die 216 may not be electrically connected to the first die 215.

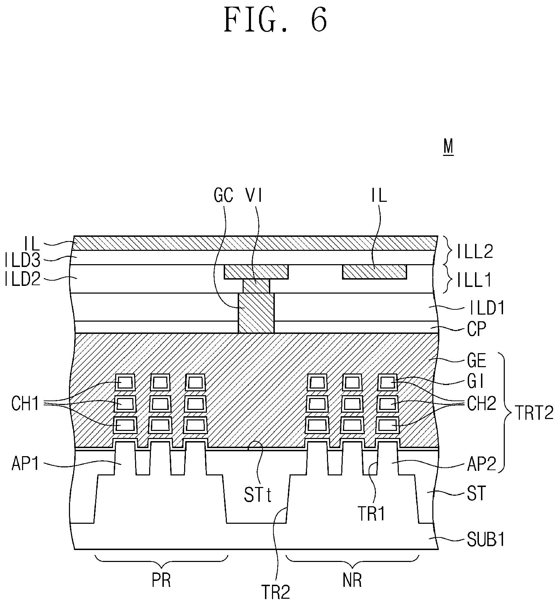

FIG. 5 is an enlarged view of region "M" of FIG. 4, according to some embodiments. FIG. 6 is an enlarged view of region "M" of FIG. 4, according to some other embodiments.

Referring to FIGS. 5 and 6, the first die 215 may include logic transistors TRT1 and TRT2 having a three-dimensional channel.

First, referring to FIG. 5, in some embodiments, the first die 215 may include the first transistor TRT1 disposed on a first substrate SUB1.

The first substrate SUB1 may include a first active region PR and a second active region NR. The first active region PR may be a PMOSFET region, and the second active region NR may be an NMOSFET region. The first active region PR and the second active region NR may be defined by a second trench TR2 formed on an upper portion of the first substrate SUB1.

A plurality of first active patterns AP1 may be provided on the first active region PR. A plurality of second active patterns AP2 may be provided on the second active region NR. The first and second active patterns AP1 and AP2 may vertically protrude from the first substrate SUB 1. A first trench TR1 may be defined between a pair of active patterns AP1/AP2 adjacent to each other.

A device isolation layer ST may be provided on the first substrate SUB 1. The device isolation layer ST may fill the first trench TR1 and the second trench TR2. For example, the device isolation layer ST may include a silicon oxide layer.

An upper portion of each of the first active patterns AP1 ma include a first channel CH1, and an upper portion of each of the second active patterns AP2 may include a second channel CH2.

The first and second channels CH1 and CH2 may be located to be higher than an upper surface STt of the device isolation layer ST. In some embodiments, the first and second channels CH1 and CH2 may vertically protrude beyond the device isolation layer ST. The first and second channels CH1 and CH2 may be in the shape of a fin that protrudes beyond the device isolation layer ST.

A gate electrode GE that extends across the first and second active patterns AP1 and AP2 may be provided. The gate electrode GE may vertically overlap the first and second channels CH1 and CH2. The gate electrode GE may be provided on an upper surface and opposite sidewalls of each of the first and second channels CH1 and CH2.

A gate dielectric layer GI may be provided between the gate electrode GE and the first and second channels CH1 and CH2. The gate dielectric layer GI may extend along a bottom surface of the gate electrode GE. The gate dielectric layer GI may cover the upper surface and the opposite sidewalls of each of the first and second channel CH1 and CH2. A gate capping layer CP may be provided on the gate electrode GE.

A first interlayer insulating layer ILD1, a second interlayer insulating layer ILD2, and a third interlayer insulating layer ILD3 that are sequentially stacked on the gate capping layer CP may be provided. A gate contact GC that penetrates the first interlayer insulating layer ILD1 and the gate capping layer CP and is electrically connected to the gate electrode GE may be provided. A first wiring layer ILL1 may be provided in the second interlayer insulating layer ILD2. A second wiring layer ILL2 may be provided in the third interlayer insulating layer ILD3. Each of the first and second wiring layers ILL1 and ILL2 may include a plurality of wires IL and a plurality of vias VI. Although not illustrated, additional wiring layers may be further provided on the second wiring layer ILL2.

In some embodiments, the channels CH1 and CH2 of the first transistors TRT1 may be located to be higher than the upper surface STt of the device isolation layer ST and may have a three-dimensional shape. That is, each of the first transistors TRT1 may be a three-dimensional transistor. For example, each of the first transistors TRT1 may be a Fin field-effect transistor (FinFET) having a fin-shaped channel.

Referring to FIG. 6, in some other embodiments, the first die 215 may include the second transistor TRT2 disposed on the first substrate SUB1.

First channels CH1 may be provided on the first active patterns AP1. The first channels CH1 may be vertically spaced from each other on the first active patterns AP1. Second channels CH2 may be provided on the second active patterns AP2. The second channels CH2 may be vertically spaced from each other on the second active patterns AP2.

The first and second channels CH1 and CH2 may be located to be higher than the upper surface STt of the device isolation layer ST. For example, a bottom surface of the first channel CH1 located at the lowermost layer from among the first channels CH1 may be higher than the upper surface STt of the device isolation layer ST.

The gate electrode GE may surround the first and second channels CH1 and CH2. The gate electrode GE may be provided on an upper surface, a bottom surface, and opposite sidewalls of each of the first and second channels CH1 and CH2. The gate dielectric layer GI may be interposed between the first and second channels CH1 and CH2 and the gate electrode GE. The gate dielectric layer GI may cover the upper surface, the bottom surface, and the opposite sidewalls of each of the first and second channels CH1 and CH2.

In some embodiments, the channels CH1 and CH2 of the second transistors TRT2 may be located to be higher than the upper surface STt of the device isolation layer ST and may have a three-dimensional shape. That is, each of the second transistors TRT2 may be a three-dimensional transistor. For example, each of the second transistors TRT2 may be a gate-all-around FET (GAAFET) in which a gate surrounds a channel.

The first transistors TRT1, the second transistors TRT2, the wires IL, and the vias VI of the first die 215 may be formed by performing the first process.

FIG. 7 is an enlarged view of region "N" of FIG. 4, according to some embodiments.

Referring to FIG. 7, a memory die may include memory transistors TRT3 having a planar gate electrode. The memory die may include the third transistor TRT3 disposed on a second substrate SUB2.

The second substrate SUB2 may include impurity regions DRP1 on an upper surface thereof. The second substrate SUB2 may be a semiconductor substrate including silicon, germanium, or silicon-germanium. The impurity regions DRP1 may be regions doped with n-type or p-type impurities. The impurity regions DRP1 doped with n-type impurities may be NMOSFET regions, and the impurity regions DRP1 doped with p-type impurities may be PMOSFET regions.

A gate electrode PGE1 may be disposed on the upper surface of the second substrate SUB2. The gate electrode PGE1 may have a planar shape on the upper surface of the second substrate SUB2. In a plan view, the gate electrode PGE1 may be in the shape of a line or a rectangle.

The gate electrode PGE1 may include a gate conductive pattern GP and a mask pattern MP that are sequentially stacked. A gate insulating layer PGI may be provided between the gate electrode PGE1 and the second substrate SUB2. In other words, the gate insulating layer PGI may be interposed between the gate conductive pattern GP and the second substrate SUB2. A pair of spacers SP may be provided on opposite sidewalls of the gate electrode PGE1.

For example, the gate conductive pattern GP may include a doped semiconductor material (e.g., doped silicon or doped germanium), conductive metal nitride (e.g., titanium nitride or tantalum nitride), or a metal material (e.g., titanium, tantalum, tungsten, copper, or aluminum). The gate insulating layer PGI may include a first insulating layer (e.g., a silicon oxide layer) and a second insulating layer (e.g., a silicon oxynitride layer) that are sequentially stacked. The spacers SP may include a silicon oxide layer, a silicon nitride layer, and/or a silicon oxynitride layer.

In some embodiments, a lower surface of the gate electrode PGE1 of the third transistor TRT3 may be located to be higher in level than the upper surface of the second substrate SUB2 and may be of a planar shape. That is, each of the third transistors TRT3 may be a two-dimensional planar transistor.

First to fourth interlayer insulating layers IDL1 to IDL4 may be sequentially stacked on the second substrate SUB2. A plurality of lower contacts DC1 that penetrate the first interlayer insulating layer IDL1 may be provided. The plurality of lower contacts DC1 may include a metal material (e.g., titanium, tantalum, tungsten, copper, or aluminum), doped silicon (or polysilicon), or doped germanium.

Some of the lower contacts DC1 may contact the impurity regions DRP1. The others of the lower contacts DC1 may penetrate the mask patterns MP and may contact the gate electrodes PGE1.

A plurality of lower wires LML1 and LML2 may be provided in the second interlayer insulating layer IDL2. In a plan view, the lower wires LML1 and LML2 may be in the shape of a line that extends on the first interlayer insulating layer IDL1. The plurality of lower lines LML1 and LML2 may include a metal material (e.g., titanium, tantalum, tungsten, copper, or aluminum), doped silicon (or polysilicon), or doped germanium.

The lower wires LML1 and LML2 may include the first and second lower wires LML1 and LML2. The first lower wire LML1 may be a bit line wire. The first lower wire LML1 may contact an impurity region through the first lower contact DC1. The second lower wire LML2 may be a word line wire WL. The word line wire WL may contact the gate electrode PGE1 through the lower contact DC1.

A plurality of upper wires UML1 may be provided on the fourth interlayer insulating layer IDL4. In a plan view, the upper wires UML1 may be in the shape of a line that extends on the third interlayer insulating layer IDL3. The plurality of upper wires UML1 may include a metal material (e.g., titanium, tantalum, tungsten, copper, or aluminum), doped silicon (or polysilicon), or doped germanium.

Upper contacts MC1 may be provided to connect the upper wires UML1 and the lower wires LML1 and LML2 and may extend through the third interlayer insulating layer IDL3. The upper contacts MC1 may include a metal material (e.g., titanium, tantalum, tungsten, copper, or aluminum), doped silicon (or polysilicon), or doped germanium.

The third transistors TRT3, the lower wires LML1 and LMI,2, the lower contacts DC1, the upper wires UML1, and the upper contacts MC1 may be formed by performing the second process. Unlike the first and second transistors TRT1 and TRT2 of FIGS. 5 and 6 formed by using the first process, the gate electrodes of the third transistors TRT3 may have a planar shape. A channel width of each of the first and second transistors TRT1 and TRT2 of FIGS. 5 and 6 formed by using the first process may be smaller than a width of the gate electrode PGE1 of each of the third transistors TRT3. Pitches of the wires and contacts in the first die 215 formed by using the first process may be smaller than those in the memory die formed by using the second process.

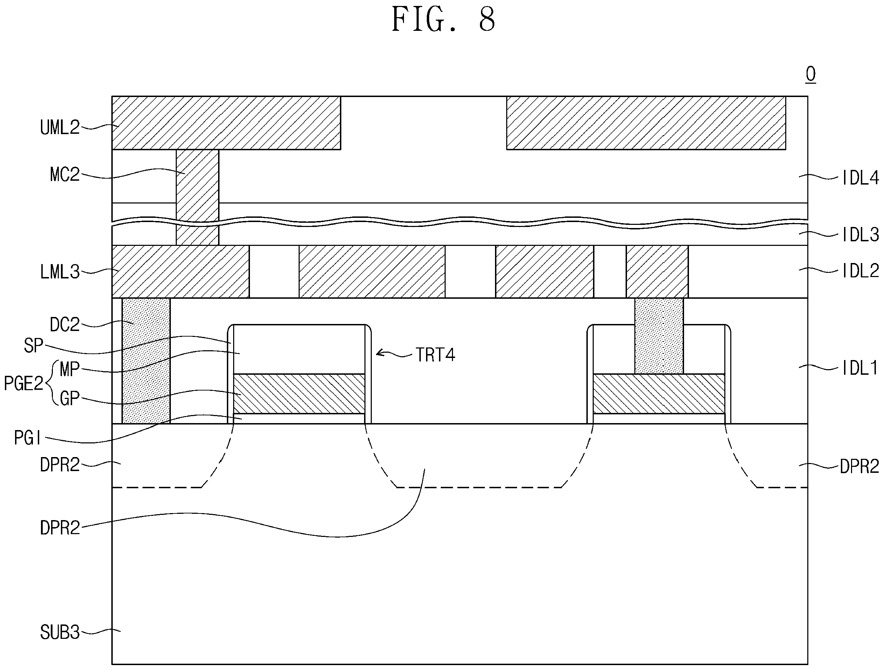

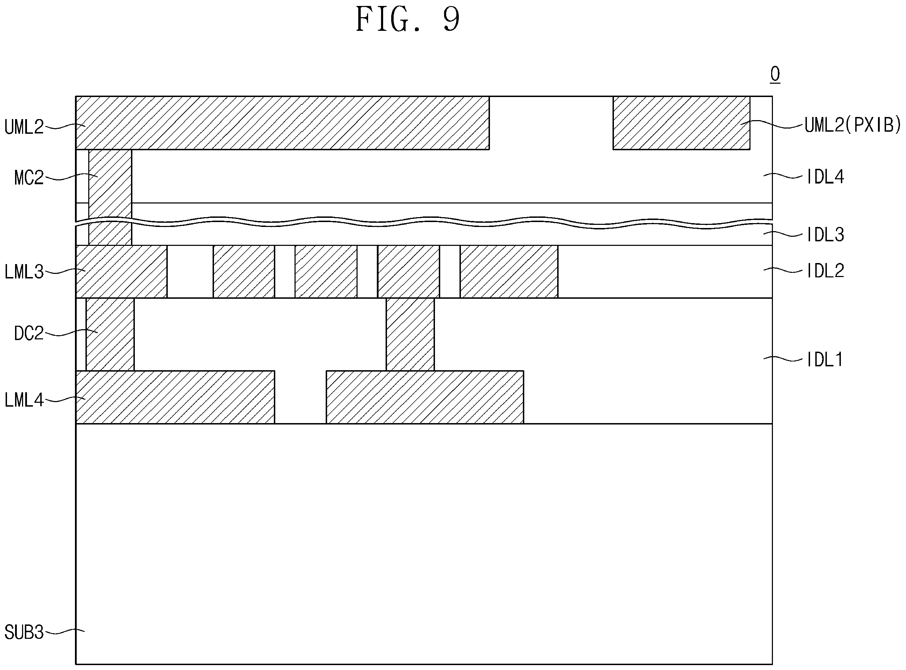

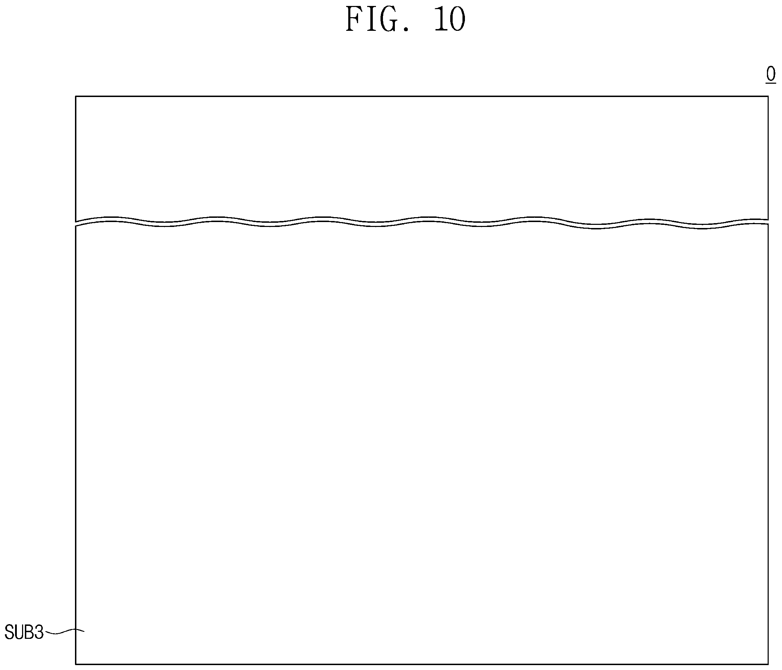

FIG. 8 is an enlarged view of region "O" of FIG. 4, according to some embodiments. FIG. 9 is an enlarged view of region "O" of FIG. 4, according to some other embodiments. FIG. 10 is an enlarged view of region "O" of FIG. 4, according to some other embodiments.

Referring to FIG. 8, the second die 216 may include transistors TRT4 having a planar gate electrode. The transistor TRT4 included in the second die 216 may be a memory transistor. As used herein, "a memory transistor" may refer to a transistor of a memory circuit.

The second die 216 may include the fourth transistor TRT4, lower contacts DC2, lower wires LML3, upper contacts MC2, and upper wires UML2 disposed on a third substrate SUB3.

In some embodiments, the second die 216 may be formed through the same process as the memory die, that is, the second process. In other words, the third substrate SUB3, the fourth transistor TRT4, the lower contacts DC2, the lower wires LMI,3, the upper contacts MC2, and the upper wires UML2 of the second die 216 may be formed through the same process as the second substrate SUB2, the third transistor TRT3, the lower contacts DC1, the lower wires LML1 and LMI,2, the upper contacts MC1, and the upper wires UML1 of the memory die of FIG. 7.

The third substrate SUB3 of the second die 216 may include a material forming the second substrate SUB2 of the memory die; likewise, each of the fourth transistor TRT4, the lower contacts DC2, the lower wires LMI,3, the upper contacts MC2, and the upper wires UML2 of the second die 216 may include a material forming each of the third transistor TRT3, the lower contacts DC1, the lower wires LML1 and LML2, the upper contacts MC1, and the upper wires UML1 of the memory die.

According to some embodiments of the present invention, unlike the first and second transistors TRT1 and TRT2 of FIGS. 5 and 6 formed by using the first process, the fourth transistors TRT4 formed by using the second process may be of a planar shape. Also, a minimum pitch of the gate electrodes in the first die 215 formed by using the first process may be smaller than that in the second die 216 formed by using the second process. In addition, a minimum line width of the wires and the contacts in the first die 215 formed by using the first process may be smaller than those in the second die 216 formed by using the second process.

Referring to FIG. 9, the second die 216 may include the lower contacts DC2, the lower wires LML3 and LML4, the upper contacts MC2, and the upper wires UML2 formed on the third substrate SUB3. In some embodiments, unlike FIG. 8, the second die 216 may not include a transistor. In some embodiments, the lower contacts DC2, the lower wires LML3 and LML4, the upper contacts MC2, and the upper wires UML2 may be formed in the same process as those in FIG. 8.

Referring to FIG. 10, the second die 216 may include the third substrate SUB3. In some embodiments, unlike FIGS. 8 and 9, the second die 216 may not include a transistor, a contact, and a wire.

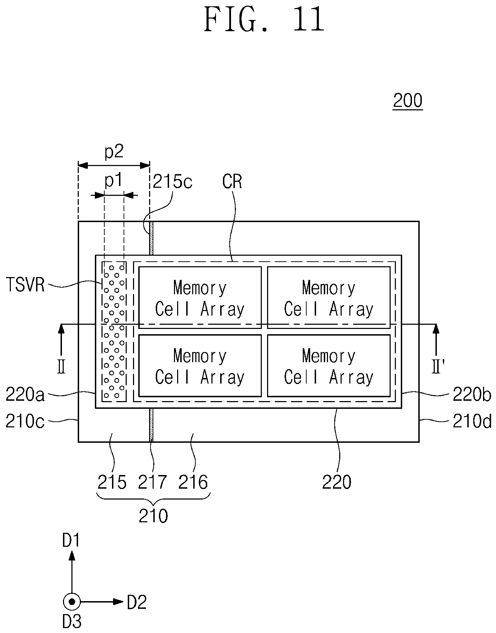

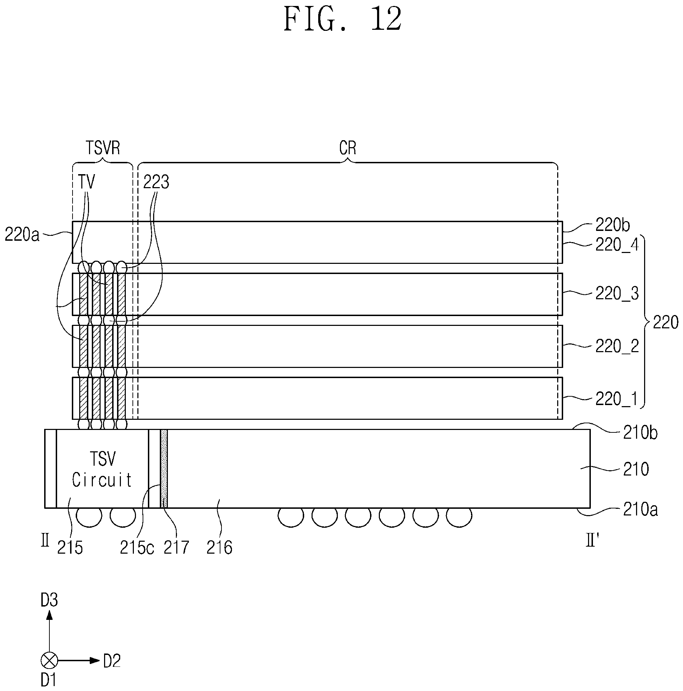

FIG. 11 is a plan view of a high-bandwidth memory device of FIGS. 1 and 2, according to some embodiments. FIG. 12 is a cross-sectional view of a high-bandwidth memory device taken along line II-II' of FIG. 11. Below, a difference with the embodiments described with reference to FIGS. 1 to 10 will be mainly described, and components that are not described may be substantially identical to the corresponding components in FIGS. 1 to 10.

Referring to FIGS. 11 and 12, the high-bandwidth memory device 200 may include the base die 210 and the memory stack 220 including the first to fourth memory dies 220_1 to 220_4 sequentially stacked on the second surface 210b of the base die 210.

Each of the first to fourth memory dies 220_1 to 220_4 may include a channel region CR and the through via region TSVR.

In some embodiments, the through via region TSVR may be located adj acent to a first side surface 220a of the memory stack 220, and the channel region CR may be located adjacent to a second side surface 220b of the memory stack 220. The first side surface 220a and the second side surface 220b may extend along the third direction D3 to be parallel to each other.

The base die 210 may include the first die 215 and the second die 216. The first die 215 and the second die 216 may be disposed side by side on the same plane. For example, the first die 215 and the second die 216 may be disposed side by side along the second direction D2. For example, the first die 215 may be disposed adjacent to a first side surface 210c of the base die 210, and the second die 216 may be disposed adjacent to a second side surface 210d of the base die 210.

In some embodiments, the second die 216 may be spaced from the first die 215. For example, the adhesive layer 217 may be provided between the first die 215 and the second die 216. In some other embodiments, unlike the example illustrated in drawing, the first die 215 and the second die 216 may be provided to directly contact each other; in this case, the adhesive layer 217 may not be provided.

The first die 215 may be disposed to vertically overlap the through via region TSVR of memory dies. For example, at least a portion of the first die 215 may overlap the through via region TSVR in the third direction D3. For example, the first side surface 220a of the memory stack 220 may vertically overlap the first die 215.

The first die 215 may include a third side surface 215c adjacent to the second die 216. The second die 216 may extend in the first direction D1 along the third side surface 215c of the first die 215.

In some embodiments, the third side surface 215c of the first die 215 may vertically overlap the channel region CR. For example, the third side surface 215c may overlap at least one of memory cell arrays on the channel region CR in the third direction D3.

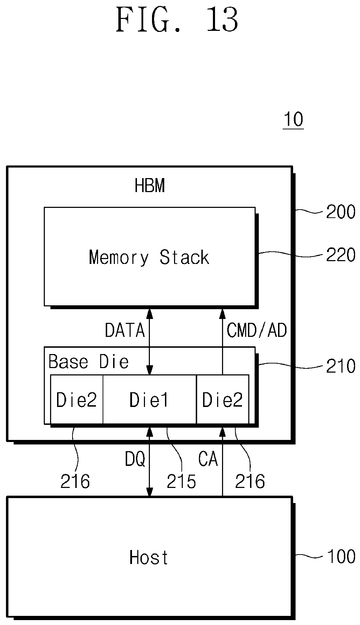

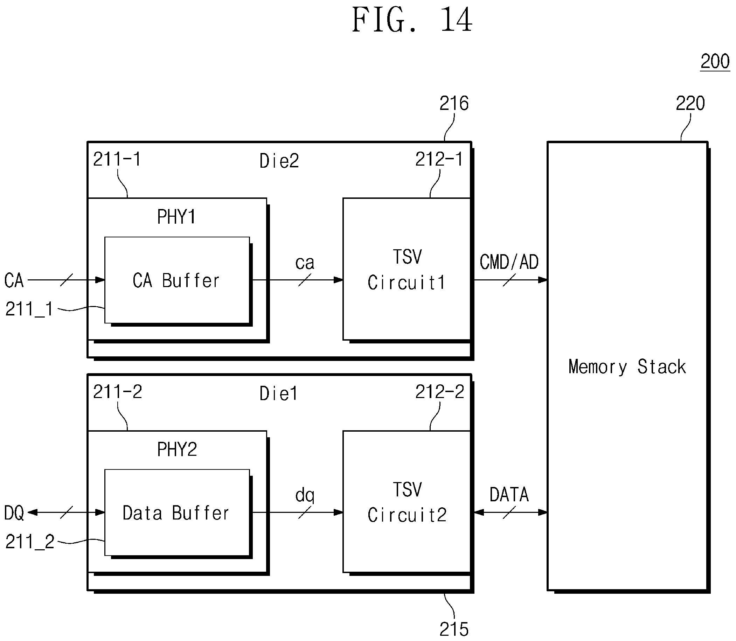

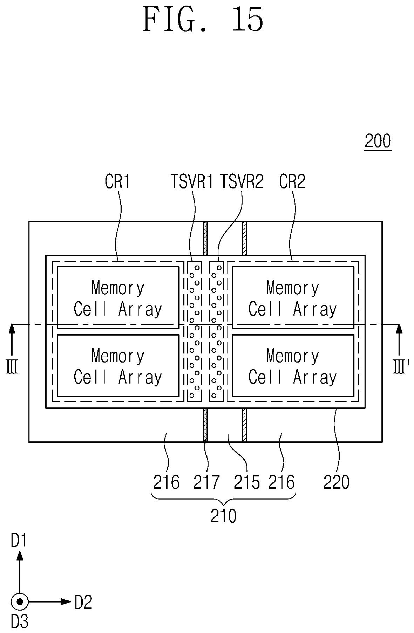

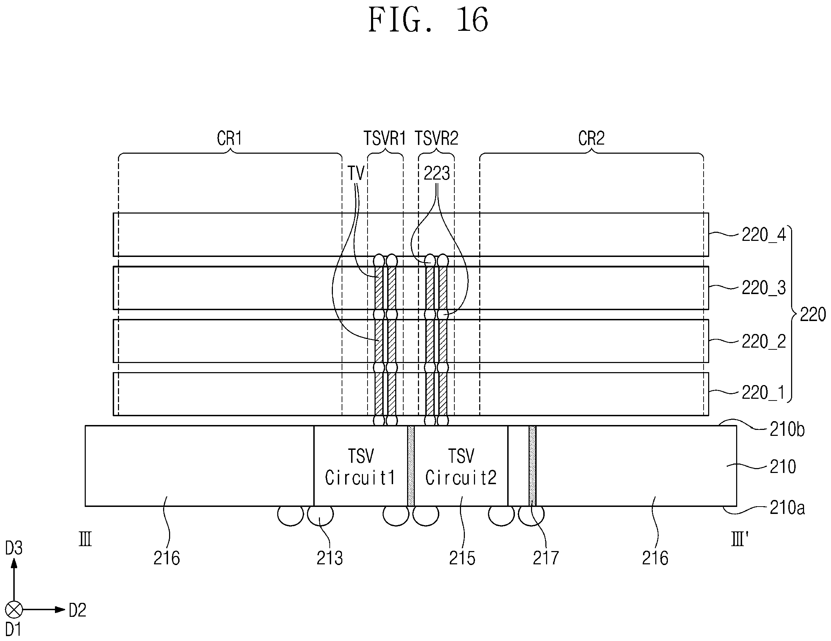

FIG. 13 is a block diagram illustrating a memory system according to some embodiments of the present invention. FIG 14 is a block diagram illustrating a configuration of a base die of FIG. 13. FIG. 15 is a plan view of a high-bandwidth memory device of FIGS. 13 and 14, according to some embodiments. FIG. 16 is a cross-sectional view of a high-bandwidth memory device taken along line III-III' of FIG. 15. Below, differences from the embodiments described with reference to FIGS. 1 to 10 will be mainly described, and components that are not described may be substantially identical to the corresponding components in FIGS. 1 to 10.

Referring to FIG. 13, the memory system 10 may include the host 100 and the high-bandwidth memory device 200.

The high-bandwidth memory device 200 may include the base die 210 and the memory stack 220. The base die 210 may include the first die 215 and the second die 216.

The first die 215 may be configured to receive the data signal DQ. The first die 215 may be configured to provide the memory stack 220 with the data "DATA" including the data information dq to be written in the memory stack 220 based on the data signal DQ. Also, the first die 215 may be configured to generate the data signal DQ based on the data "DATA" read from the memory stack 220.

The second die 216 may be configured to receive the command address signal CA from the host 100. The second die 216 may be configured to provide the memory stack 220 with the command/address CMD/AD including command address ca, based on the command address signal CA.

However, the present invention is not limited thereto. For example, the second die 216 may further include integrated circuits configured to control the memory operation of the high-bandwidth memory device 200.

The second die 216 may be provided on the side surface of the first die 215. The second die 216 may be configured to operate at a speed lower than the operating speed of the first die 215. For example, the second die 216 may include integrated circuits that operate at low speed. In contrast, the first die 215 may include integrated circuits that require a high-speed operation. For example, a frequency of a data signal that is transferred from the host 100 to the first die 215 may be lower than a frequency of a command address signal that is transferred from the host 100 to the second die 216.

According to some embodiments of the present invention, the first die 215 requiring the high-speed operation may be formed by performing the first process, and the second die 216 and the memory die requiring the low-speed operation may be formed by performing the second process. According to the present invention, the degree of integration and the operating speed of the high-bandwidth memory device 200 may be improved compared to the case where the entire base die 210 is formed by using the second process, and manufacturing costs may be reduced compared to the case where the entire base die 210 is formed by using the first process.

Referring to FIG. 14, the second die 216 may include a first physical layer interface 211-1 and a first TSV circuit 212-1.

The first physical layer interface 211-1 may be configured to store the command address signal ca based on the command address signal CA received from the host 100.

The first physical layer interface 211-1 may include the command address buffer 211_1. The command address buffer 211_1 may be configured to store the command address information ca based on the command address signal CA received through the host 100. The command address buffer 211_1 may be configured to provide the stored command address information ca to the first TSV circuit 212-1.

The first TSV circuit 212-1 may be electrically connected to the memory stack 220. The first TSV circuit 212-1 may be configured to receive the command address information ca from the first physical layer interface 211-1. The first TSV circuit 212-1 may be configured to provide the memory stack 220 with the command/address CMD/AD based on the received command address information ca.

The first die 215 may include a second physical layer interface 211-2 and a second TSV circuit 212-2.

The second physical layer interface 211-2 may be configured to store the data information dq based on the data signal DQ received from the host 100.

The second physical layer interface 211-2 may include the data buffer 211_2. The data buffer 211_2 may be configured to store the data information dq based on the data signal DQ received through the host 100. The data buffer 211_2 may be configured to provide the stored data information dq to the second TSV circuit 212-2.

The second TSV circuit 212-2 may be electrically connected to the memory stack 220. The second TSV circuit 212-2 may be configured to receive the data information dq from the second physical layer interface 211-2. The second TSV circuit 212-2 may be configured to provide the data "DATA" to the memory stack 220 based on the received data information dq.

When the read operation is performed, the second TSV circuit 212-2 may be configured to receive the data "DATA" from the memory stack 220 and to provide the data information dq to the second physical layer interface 211-2.

Referring to FIGS. 15 and 16, the high-bandwidth memory device 200 may include the base die 210 and the memory stack 220 including the first to fourth memory dies 220_1 to 220_4 sequentially stacked on the second surface 210b of the base die 210.

Each of the first to fourth memory dies 220_1 to 220_4 may include the first cell region CR1, the second cell region CR2, a first through via region TSVR1, and a second through via region TSVR2.

In each of the first to fourth memory dies 220_1 to 220_4, the through via regions TSVR1 and TSVR2 may be defined as a region where the through vias TV of each memory die are formed. The terminals 223 may be provided on the through via regions TSVR1 and TSVR2. The terminals 223 may be micro terminals. The through vias TV may be respectively connected to the terminals 223 on the through via regions TSVR1 and TSVR2. The through vias TV may be configured to penetrate memory dies.

Each memory die may receive the data "DATA" and the command/address CMD/AD from the base die 210 through the terminals 223 and the through vias TV connected thereto. For example, each memory die may receive the command/address CMD/AD from the second die 216 through the terminals 223 on the first through via region TSVR1 and the through vias TV connected thereto. For example, each memory die may receive the data "DATA" from the first die 215 through the terminals 223 on the second through via region TSVR2 and the through vias TV connected thereto.

The through via regions TSVR1 and TSVR2 may be disposed between the first cell region CR1 and the second cell region CR2. For example, the first cell region CR1, the first through via region TSVR1, the second through via region TSVR2, and the second cell region CR2 may be sequentially disposed along the second direction D2.

The base die 210 may include the first die 215 and the second dies 216. The first die 215 and the second die 216 may be configured to be electrically connected to the memory stack 220. The first die 215 may be disposed between a pair of second dies 216.

In the base die 210, the area occupied by the second dies 216 may be larger than the area occupied by the first die 215. For example, the second dies 216 may occupy 50% to 90% of the base die 210, and the first die 215 may occupy the remaining 10% to 50% of the base die 210. In some embodiments of the present invention, as the occupying area of the second dies 216 in the base die 210 increases, manufacturing costs of the base die 210 may be further reduced.

One of the second dies 216 may be disposed to vertically overlap the first through via region TSVR1. For example, at least a portion of the second die 216 may overlap the first through via region TSVR1 in the third direction D3.

The first die 215 may be disposed to vertically overlap the second through via region TSVR2 of memory dies. For example, at least a portion of the first die 215 may overlap the second through via region TSVR2 in the third direction D3.

The connection terminals 213 may be provided on a first surface of the base die 210. For example, the connection terminals 213 provided on the lower surface of the first die 215 may be configured to receive various kinds of signals from the host 100 of FIG. 1. For example, the connection terminals 213 provided on the lower surface of the second die 216 may be configured to be electrically connected to the second dies 216.

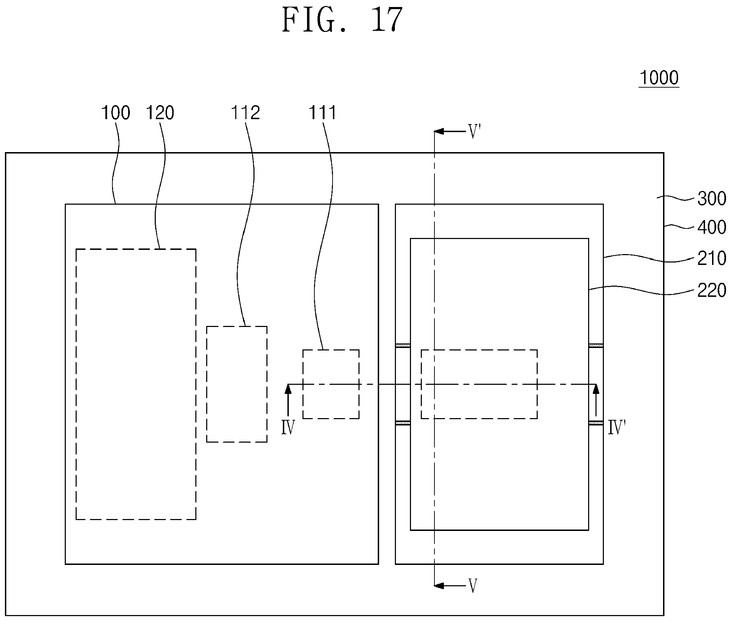

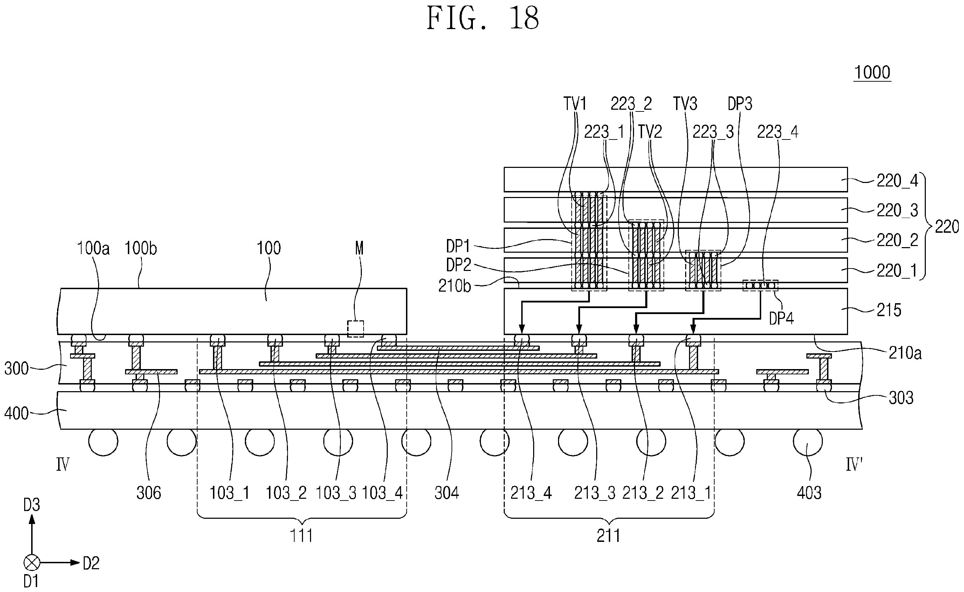

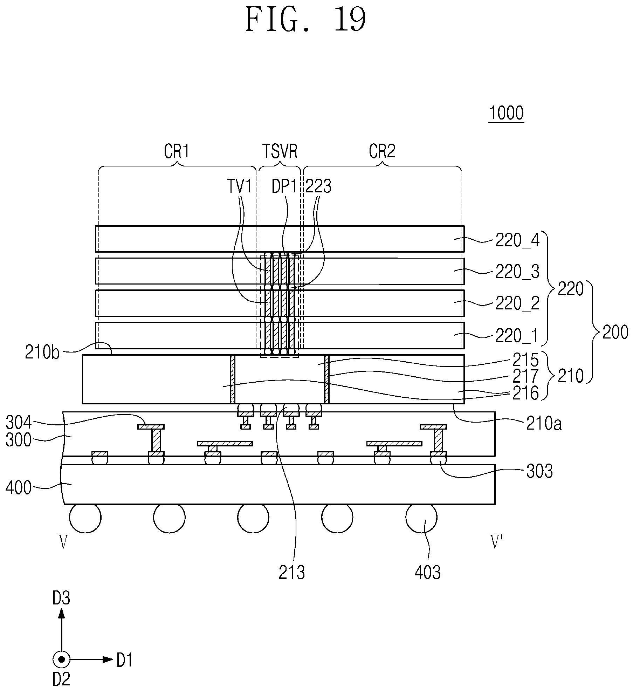

FIG. 17 is a plan view of a semiconductor package including a high-bandwidth memory device according to some embodiments of the present invention. FIG. 18 is a cross-sectional view of a semiconductor package taken along line IV-IV' of FIG. 17. FIG. 19 is a cross-sectional view of a semiconductor package taken along line V-V' of FIG. 17.

Referring to FIGS. 17 to 19, a package substrate 400 may be provided. An interposer substrate 300 may be provided on the package substrate 400. For example, the package substrate 400 may include a printed circuit board (PCB). The interposer substrate 300 may be a redistribution layer (RDL) substrate. Terminals 303 may be provided on a bottom surface of the interposer substrate 300. The terminals 303 may be interposed between the interposer substrate 300 and the package substrate 400. Solder balls 403 may be provided on a bottom surface of the package substrate 400. Although not illustrated, the package substrate 400 may include routing wires and at least one via therein.

A logic die 100 and the high-bandwidth memory device 200 may be disposed on the interposer substrate 300. The number of high-bandwidth memory devices 200 disposed on the interposer substrate 300 may be variously changed or modified. The high-bandwidth memory device 200 and the logic die 100 may be mounted side by side on the interposer substrate 300.

The logic die 100 may include a central processing unit 120, a host physical layer interface 111, and a memory controller 112. As the host 100 of FIG. 1, the logic die 100 may be configured to generate a data signal and a command address signal for controlling the high-bandwidth memory device 200.

For example, the logic die 100 may be a system on chip. The logic die 100 may have a first surface 100a facing the interposer substrate 300 and a second surface 100b facing away from or opposite the first surface 100a.

The logic die 100 may include the logic transistors TRT1 and TRT2 and the wiring layers ILL1 and ILL2 described with reference to FIGS. 5 and 6. The logic die 100 may be mounted on the interposer substrate 300 in a face-down state of facing the interposer substrate 300.

First connection terminals 103_1 to 103_4 may be interposed between the logic die 100 and the interposer substrate 300. For example, the first connection terminals 103_1 to 103_4 may include the first terminal 103_1, the second terminal 103_2, the third terminal 103_3, and the fourth terminal 103_4. For example, each of the first connection terminals 103_1 to 103_4 may be a micro terminal.

The logic die 100 may be mounted on the interposer substrate 300 by the first connection terminals 103_1 to 103_4 in a flip chip bonding scheme. Although not illustrated, an underfill resin layer may be filled between the logic die 100 and the interposer substrate 300.

The high-bandwidth memory device 200 may include the base die 210 and the first to fourth memory dies 220_1 to 220_4 sequentially stacked on the base die 210. The base die 210 may include the first die 215 and the second die 216. The high-bandwidth memory device 200 may be similar to those of the embodiments described with reference to FIGS. 1 to 16.

The base die 210 may have the first surface 210a facing the interposer substrate 300 and the second surface 210b facing away from or opposite the first surface 210a. The base die 210 may be mounted on the interposer substrate 300 in a face-down state of facing the interposer substrate 300.

Second connection terminals 213_1 to 213_4 may be interposed between the base die 210 and the interposer substrate 300. For example, the second connection terminals 213_1 to 213_4 may include the first terminal 213_1, the second terminal 213_2, the third terminal 213_3, and the fourth terminal 213_4. For example, each of the second connection terminals 213_1 to 213_4 may be a micro terminal.

The base die 210 may be mounted on the interposer substrate 300 by the second connection terminals 213_1 to 213_4 in a flip chip bonding scheme. Although not illustrated, an underfill resin layer may be filled between the base die 210 and the interposer substrate 300.

The third memory die 220_3 may include first through vias TV1 penetrating the inside of the third memory die 220_3. The second memory die 220_2 may include the first through vias TV1 and second through vias TV2 penetrating the inside of the second memory die 220_2. The first memory die 220_1 may include the first through vias TV1, the second through vias TV2, and the third through vias TV3 penetrating the inside of the first memory die 220_1. The fourth memory die 220_4 may not include the through vias TV, but the present invention is not limited thereto.

First data terminals 223_1 may be provided between the fourth memory die 220_4 and the first through vias TV1 of the third memory die 220_3. The first data terminals 223_1 between the third and fourth memory dies 220_3 and 220_4 may be electrically connected to the fourth memory die 220_4. The first data terminals 223_1 may be further provided between the first through vias TV1 of the third memory die 220_3 and the first through vias TV1 of the second memory die 220_2. The first data terminals 223_1 may be further provided between the first through vias TV1 of the second memory die 220_2 and the first through vias TV1 of the first memory die 220_1. The first data terminals 223_1 may be further provided between the first through vias TV 1 of the first memory die 220_1 and the base die 210.

A first data input/output path DP1 of the high-bandwidth memory device 200 may include the first data terminals 223_1 interposed between memory dies and the first through vias TV1 penetrating the memory dies. The first data terminals 223_1 and the first through vias TV1 may be alternately stacked to form a vertical data path (e.g., the first data input/output path DP1). The first data terminals 223_1 and the first through vias TV1 of the first data input/output path DP1 may vertically overlap each other. The fourth memory die 220_4 may be electrically connected to the base die 210 through the first data input/output path DP1. Data may be exchanged between the fourth memory die 220_4 and the base die 210 through the first data input/output path DP1.

Second data terminals 223_2 may be provided between the third memory die 220_3 and the second through vias TV2 of the second memory die 220_2. The second data terminals 223_2 between the second and third memory dies 220_2 and 220_3 may be electrically connected to the third memory die 220_3. The second data terminals 223_2 may be further provided between the second through vias TV2 of the second memory die 220_2 and the second through vias TV2 of the first memory die 220_1. The second data terminals 223_2 may be further provided between the second through vias TV2 of the first memory die 220_1 and the base die 210.

A second data input/output path DP2 of the high-bandwidth memory device 200 may include the second data terminals 223_2 interposed between memory dies and the second through vias TV2 penetrating the memory dies. The second data terminals 223_2 and the second through vias TV2 may be alternately stacked to form a vertical data path (e.g., the second data input/output path DP2). The second data terminals 223_2 and the second through vias TV2 of the second data input/output path DP2 may vertically overlap each other. The third memory die 220_3 may be electrically connected to the base die 210 through the second data input/output path DP2. Data may be exchanged between the third memory die 220_3 and the base die 210 through the second data input/output path DP2.

Third data terminals 223_3 may be provided between the second memory die 220_2 and the third through vias TV3 of the first memory die 220_1. The third data terminals 223_3 between the first and second memory dies 220_1 and 220_2 may be electrically connected to the second memory die 220_2. The third data terminals 223_3 may be further provided between the third through vias TV3 of the first memory die 220_1 and the base die 210.

A third data input/output path DP3 of the high-bandwidth memory device 200 may include the third data terminals 223_3 interposed between dies and the third through vias TV3 penetrating the memory die. The third data terminals 223_3 and the third through vias TV3 may be alternately stacked to form a vertical data path (e.g., the third data input/output path DP3). The third data terminals 223_3 and the third through vias TV3 of the third data input/output path DP3 may vertically overlap each other. The second memory die 220_2 may be electrically connected to the base die 210 through the third data input/output path DP3. Data may be exchanged between the second memory die 220_2 and the base die 210 through the third data input/output path DP3.

Fourth data terminals 223_4 may be provided between the first memory die 220_1 and the base die 210. The fourth data terminals 223_4 may be electrically connected to the first memory die 220_1.

A fourth data input/output path DP4 of the high-bandwidth memory device 200 may include the fourth data terminals 223_4 interposed between dies. The first memory die 220_1 may be electrically connected to the base die 210 through the fourth data input/output path DP4. Data may be exchanged between the first memory die 220_1 and the base die 210 through the fourth data input/output path DP4.

The logic die 100 may include the host physical layer interface region 111. The base die 210 of the high-bandwidth memory device 200 may include the physical layer interface region 211

In detail, the interposer substrate 300 may include a plurality of conductive lines 304. The base die 210 may receive a data signal and a command address signal from the logic die 100 through the conductive lines 304.

Through the conductive lines 304, the first terminal 103_1 and the first terminal 213_1 may be electrically connected, the second terminal 103_2 and the second terminal 213_2 may be electrically connected, the third terminal 103_3 and the third terminal 213_3 may be electrically connected, and the fourth terminal 103_4 and the fourth terminal 213_4 may be electrically connected.

Example embodiments of the present invention provide a memory device capable of improving an operating speed and reducing manufacturing costs.

As used herein, an element or region that is "covering" or "surrounding" or "filling" another element or region may completely or partially cover or surround or fill the other element or region. Further, as used herein, "an element A connected to an element B" (or similar language) may mean that the element A is electrically connected to the element B and/or the element A contacts the element B.

Although terms (e.g., first, second or third) may be used herein to describe various elements, these elements should not be limited by these terms. These terms are only used to distinguish one element from another. For example, a first element may be referred to as a second element, and, similarly a second element may be referred to as a first element without departing from the teachings of the disclosure.

It is noted that aspects of the present invention described with respect to one embodiment, may be incorporated in a different embodiment although not specifically described relative thereto. That is, all embodiments and/or features of any embodiment can be combined in any way and/or combination. These and other objects and/or aspects of the present invention are explained in detail in the specification set forth below.

While the present invention has been described with reference to embodiments thereof, it will be apparent to those of ordinary skill in the art that various changes and modifications may be made thereto without departing from the scope of the present invention. Accordingly, the above-disclosed subject matter is to be considered illustrative, and not restrictive, and the appended claims are intended to cover all such modifications, enhancements, and other embodiments, which fall within the scope of the present invention. Thus, to the maximum extent allowed by law, the scope is to be determined by the broadest permissible interpretation of the following claims and their equivalents, and shall not be restricted or limited by the foregoing detailed description.

## Claims

1. A memory device comprising:
a base die structure including a first die and a second die; and
a memory stack including memory dies sequentially stacked on the base die structure in a vertical direction,
wherein the first die is configured to be electrically connected to the memory stack, and
wherein the first die includes a transistor of a logic circuit, and the transistor of the logic circuit includes a channel of a three-dimensional structure.

2. The memory device of claim 1, wherein the first die includes a physical layer interface and a through silicon via (TSV) circuit.

3. The memory device of claim 1, wherein the memory stack includes through vias that are in the memory dies,
wherein each of the memory dies includes a through via region including terminals electrically connected to the through vias, respectively, and
wherein at least a portion of the first die overlaps the through via region in the vertical direction.

4. The memory device of claim 3, wherein a width of the first die is greater than a width of the through via region.

5. The memory device of claim 3, wherein each of the memory dies includes a first cell region and a second cell region, the first and second cell regions including memory cell areas, and
wherein the through via region is between the first cell region and the second cell region.

6. The memory device of claim 5, wherein a first side surface of the first die overlaps the first cell region in the vertical direction, and
wherein a second side surface of the first die, which is opposite the first side surface of the first die, overlaps the second cell region in the vertical direction.

7. The memory device of claim 1, wherein the transistor of the logic circuit includes a Fin field-effect transistor (FinFET) or a gate-all-around field-effect transistor (GAAFET).

8. The memory device of claim 7, wherein the second die includes a transistor of a memory circuit including a planar gate electrode.

9. The memory device of claim 1, wherein a minimum pitch of a gate electrode of the first die is smaller than a minimum pitch of a gate electrode of the second die.

10. A memory system comprising:
a host configured to generate a data signal and a command address signal; and
a memory device configured to receive the data signal and the command address signal from the host,
wherein the memory device includes:
a base die structure including a first die configured to receive the data signal and a second die configured to receive the command address signal; and
a memory stack including memory dies sequentially stacked on the base die structure in a vertical direction,
wherein the first die includes a transistor of a logic circuit, and the transistor of the logic circuit includes a channel of a three-dimensional structure.

11. The memory system of claim 10, wherein the second die includes:
a first physical layer interface configured to receive the command address signal; and
a first TSV circuit configured to provide a command signal to the memory stack, wherein the first die includes:
a second physical layer interface configured to receive the data signal; and
a second TSV circuit configured to provide data to the memory stack.

12. The memory system of claim 10, wherein the memory stack includes through vias in the memory dies,
wherein each of the memory dies includes a first through via region and a second through via region, and the first and second through via regions include terminals connected to the through vias,
wherein at least a portion of the second die overlaps the first through via region in the vertical direction, and
wherein at least a portion of the first die overlaps the second through via region in the vertical direction.

13. The memory system of claim 10, wherein the transistor of the logic circuit includes a Fin field-effect transistor (FinFET) or a gate-all-around field-effect transistor (GAAFET).

14. The memory system of claim 10, wherein the second die includes a transistor of a memory circuit including a planar gate electrode.

15. The memory system of claim 10, wherein a minimum pitch of a gate electrode of the first die is smaller than a minimum pitch of a gate electrode of the second die.
